# EUROPEAN PATENT APPLICATION

(11) **EP 4 528 945 A1**
(43) Date of publication of application: **26.03.2025**
(21) Application number: 23199013.6
(22) Date of filing: 22.09.2023
(51) Int. Cl.: H01S 5/183, H01S 5/024, H01S 5/042

(54) **RADIATION EMITTER AND METHOD OF FABRICATING RADIATION EMITTERS**

(71) Applicant: Changchun Institute of Optics, Fine Mechanics and Physics, Chinese Academy of Sciences, Jilin 130033 (CN)
(72) Inventor: TIAN, Sicong, Changchun Jilin, 130033 (CN); BIMBERG, Dieter, 14089 Berlin (DE); MOHAMMED ALTHOF MARICAR, Mansoor Ahamed, Changchun, Jilin, 130033 (CN)
(74) Representative: Fischer, Uwe

(57) **Abstract**

An exemplary embodiment of the invention relates to a method of fabricating a radiation emitter (100) comprising the steps of fabricating a lower layer stack (20) on top of a substrate (10), the lower layer stack (20) comprising a lower contact layer (21) and at least one lower reflector (22), fabricating an intermediate layer stack (30) on top of the lower layer stack (20), the intermediate layer stack (30) comprising at least one active layer (31) and at least one aperture layer (32), fabricating an upper layer stack (40) on top of the intermediate layer stack (30), the upper layer stack (40) comprising at least one upper reflector (42) and an upper contact layer (41), and forming a mesa that at least comprises a mesa section of the upper layer stack (40), by locally removing at least the upper layer stack (40). After or before forming the mesa, at least one blind hole (60) having a depth (D) smaller than the thickness (T) of the upper layer stack (40) is etched inside the mesa section of the upper layer stack (40), and the at least one blind hole (60) is filled with a thermally conductive material (70).

## Description

### Background of the invention

Vertical Cavity Surface Emitting Lasers (VCSELs) and Edge Emitting Lasers (EELs) are key devices for a rapidly increasing spectrum of systems. It is known, that VCSELs are the dominating light sources for short and medium reach interconnects in workstation clusters or supercomputers due to their large bitrate in concert with a small energy consumption per bit. Both parameters - increase of bitrate and energy consumption (defined by energy to data ratio EDR) - are presently the subjects of large progress. There exists a trade-off between these parameters. The EDR increases rapidly with increasing bit rate. The optimal properties of a VCSEL for a given system thus depends on its bitrate [Larisch et al. Optics Express 28, 6, 2020).

There is large demand for increasing the capacity of given or future work station clusters by further increasing the bit rates of their optical interconnects, in particular the light emitting VCSELs. Their bit rates increase with the square root of the drive current. Increasing this current is limited by the saturation of the output power at a given saturation current, beyond that the output power decreases. This saturation is a result of heating of the active area of the device, shifting its wavelength of emission out of resonance with the narrow transmission curve of the output mirror, consisting typically of a Bragg reflector.

The workload of a workstation cluster or a supercomputer is volatile. Processors are rapidly adapting their performance and energy consumption depending on actual demand. State-of-the-art processors have different cores for different workloads. The operating parameters of a present VCSEL, being the light source of an active optical cable connecting work stations to each other however, cannot be adapted to the varying workload of e.g. a network, a work station cluster,... and is thus operating typically under non-optimum conditions, like larger energy or cooling water consumption than necessary.

Methods of fabricating radiation emitters according to the preamble of claim 1 are known in the art in connection with the fabrication of VCSELs and EELs.

### Objective of the present invention

In view of the above, an objective of the present invention is to propose a radiation emitter with improved thermal characteristic.

A further objective of the present invention is to provide a method for fabricating a radiation emitter that shows an optimized thermal characteristic.

### Brief summary of the invention

An exemplary embodiment of the present invention relates to a method according to claim 1.

An advantage of this embodiment of the invention is, that the at least one blind hole filled with a thermally conductive material provides a thermal bypass that reduces the thermal resistance of the upper layer stack and thus reduces the temperature of the active light emitting area of the radiation emitter. For instance, heat that is generated inside the active layer by nonradiative recombination or by series resistance in the device, may use the bypass to pass through the upper portion of the upper layer stack in order to reach the outer surface of the radiation emitter, thereby providing an optimized heat transfer compared to radiation emitters without such thermal bypasses. As such, the method according the present invention allows for instance fabricating Surface Emitting lasers (or VCSELs) or Edge Emitting lasers (EEL) with large heat conductivity. Further, for instance, it is possible to increase the possible light output power and the bit rate, by reducing the temperature of the active area for a given current and thus increasing the saturation current.

Another advantage is that the operating temperature range is increased compared to emitters without filled blind holes.

Since the blind holes vertically end in the upper layer stack and therefore above all active layers and above all aperture layers of the radiation emitter, the active and aperture layers remain unaffected by the thermal bypasses. In other words, all active layers and all aperture layers are located in the intermediate layer stack and therefore exclusively below the upper layer stack to make sure that the filled blind holes (i.e. the bypasses) do not interact with the active layer(s) and the aperture layer(s).

Suitable thermally conductive materials are for instance metals such as Gold, Silver, Platinum, Titanium and Nickel, alloys of such metals, electrically isolating materials such as glass or ceramics, electrically conductive polymers, or electrically conductive oxides, preferably transparent electrically conductive oxides, such as indium tin oxide (ITO), fluorine doped tin oxide (FTO), aluminium doped zinc oxide (AZO), carbon or carbon nanotubes.

The thermal conductivity of the thermally conductive material preferably exceeds 200 W/(K·m) at a temperature of 300 K.

If the blind holes are filled with a thermally and electrically conductive material, the electrical resistance of the upper layer stack and therefore the heat production are also reduced and thereby the performance of the resulting radiation emitter may be further improved. In the latter case, the filled blind holes form both electrical and thermal bypasses.

The filled blind holes preferably terminate below the upper reflector and above the intermediate layer stack, for instance directly above the intermediate layer stack, and therefore vertically extend through the entire upper reflector, such that heat, and in case of electrically conductive bypasses also the electrical current, can bypass the upper reflector.

The lower contact layer is preferably provided with a lower contact material to form a lower electric contact of the radiation emitter, and the upper contact layer is preferably provided with an upper contact material to form an upper contact of the radiation emitter.

The step of filling the at least one blind hole with the thermally conductive material and the step of providing the upper contact layer with the upper contact material may be independent steps, wherein the step of providing the upper contact layer with the upper contact material is preferably carried out after the step of filling the at least one blind hole with the thermally conductive material.

The upper contact material and the thermally conductive material may be different materials.

Alternatively, the upper contact material and the thermally conductive material can be the same material.

The step of filling the at least one blind hole with the thermally conductive material and the step of providing the upper contact layer with the upper contact material may alternatively be carried out in a single contacting step, for instance a single metallization step. In the latter case, the upper contact material and the thermally conductive material are preferably the same material.

After forming the mesa, the at least one aperture layer is preferably subjected to a lateral oxidation step to provide an unoxidized aperture that is laterally surrounded by oxidized material.

Alternatively, the aperture layer may be laterally oxidized to form one or more apertures before forming the mesa. The lateral oxidation may for instance be carried out through oxidation holes that are deeper than said blind holes and vertically extend to the aperture layer, as for instance described in the European Patent publications EP 3 961 829 A1, EP 3 961 830 A1, and EP 4 007 092 B1.

The at least one blind hole may be etched and filled with the thermally conductive material after forming the mesa. In this case, the at least one blind hole is preferably filled with the thermally conductive material before laterally oxidizing the aperture layer in order to protect the interior wall of the blind holes from the oxidation process.

Alternatively, the at least one blind hole may be etched after laterally oxidizing the aperture layer.

The at least one blind hole may also be etched before forming the mesa. In the latter case, the at least one blind hole is preferably filled with the thermally conductive material before laterally oxidizing the aperture layer.

Said step of forming the mesa preferably includes removing the intermediate layer stack or at least an upper portion of the intermediate layer stack, wherein the upper portion of the intermediate layer stack comprises the at least one aperture layer.

The size, i.e. diameter of the mesa, is preferably in the range between 10 and 100 um. In this case, the size of the mesa is adapted to the typical diameter (50 um or 62,5 µm) of the core of a standard multimode fiber and butt-coupling between a standard multimode fiber and the mesa is possible.

The radiation emitter preferably forms a vertical emitting laser (VCSEL).

The mesa may have steps.

Another exemplary embodiment of the present invention relates to a radiation emitter according to claim 14. The radiation emitter is preferably fabricated as outlined above.

Preferably, a plurality of filled blind holes that each form a bypass and have a depth smaller than the thickness of the upper layer stack, are located inside the upper layer stack of the mesa.

### Brief description of the drawings

In order that the manner, in which the above-recited and other advantages of the invention are obtained, will be readily understood, a more particular description of the invention briefly described above will be rendered by reference to specific embodiments thereof, which are illustrated in the appended figures. Understanding that these figures depict only typical embodiments of the invention and are therefore not to be considered limiting its scope, the invention will be described and explained with additional specificity and detail by the use of the accompanying drawings in which
- Figures 1-6: illustrate method steps of a first exemplary embodiment of a method of fabricating a radiation emitter according to the present invention,
- Figures 7-12: illustrate method steps of a second exemplary embodiment of a method of fabricating a radiation emitter according to the present invention,
- Figures 13-14: illustrate method steps of a third and fourth exemplary embodiment of a method of fabricating a radiation emitter according to the present invention, and
- Figures 15-16: illustrate method steps of a fifth exemplary embodiment of a method of fabricating a radiation emitter according to the present invention.

### Detailed description of the preferred embodiments

The preferred embodiments of the present invention will be best understood by reference to the drawings, wherein identical or comparable parts are designated by the same reference signs throughout.

It will be readily understood that the parameters of the embodiments of the present invention, as generally described herein, could vary in a wide range. Thus, the following more detailed description of exemplary embodiments of the present invention, is not intended to limit the scope of the invention but is merely representative of presently preferred embodiments of the invention.

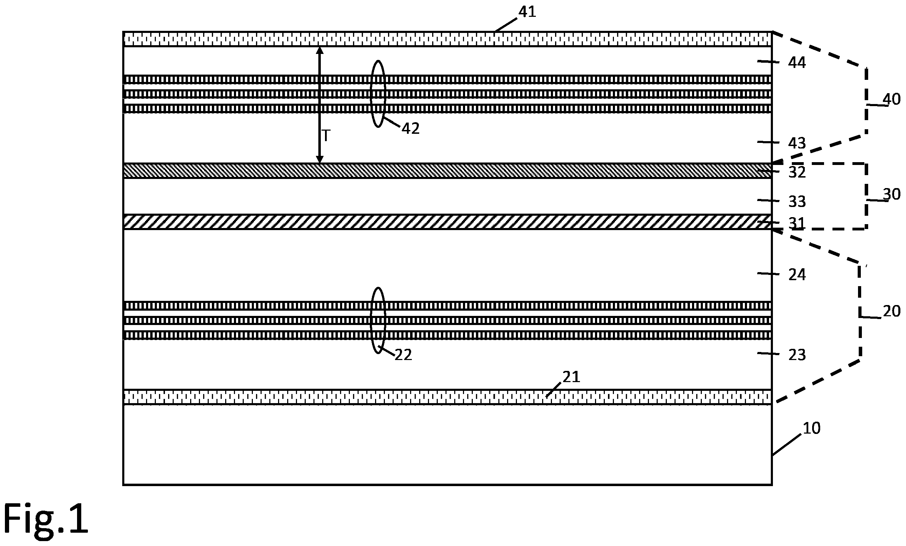

Figures 1-6 depict a first exemplary embodiment of a method of fabricating a radiation emitter according to the present invention.

Figure 1 shows a substrate 10 on which a lower layer stack 20, an intermediate layer stack 30 and an upper layer stack 40 have been fabricated. The layers of the layer stacks may be deposited by chemical vapour deposition or molecular beam epitaxy or similar thin layer deposition methods as known in the art.

The lower layer stack 20 is formed on top of the substrate 10 and comprises a lower contact layer 21, a lower reflector 22, and an additional layer 23. The additional layer 23 separates the lower reflector 22 from the lower contact layer 21. The lower layer stack 20 may comprise further layers. Such further layers may separate the lower reflector 22 from the intermediate layer stack 30. In Figure 1, such a further layer is designated by reference number 24.

The intermediate layer stack 30 is formed on top of the lower layer stack 20 and comprises an active layer 31, an aperture layer 32 and an intermediate layer 33 which separates the active layer 31 from the aperture layer 32. The intermediate layer stack 30 may comprise further layers which are not shown in Figure 1. Such further layers may separate the active layer 31 and/or the aperture layer 32 from the upper and/or lower layer stack. The active layer 31 may be above or below the aperture layer 32. Furthermore, there may be one or more aperture layers above the active layer and/or one or more aperture layers below the active layer.

The upper layer stack 40 is formed on top of the intermediate layer stack 30 and comprises an upper contact layer 41, an upper reflector 42, and additional layers 43 und 44. The additional layers 43 and 44 separate the upper reflector 42 from the intermediate layer stack 30 and the upper reflector 42 from the upper contact layer 41, respectively. The upper layer stack 40 may comprise further additional layers.

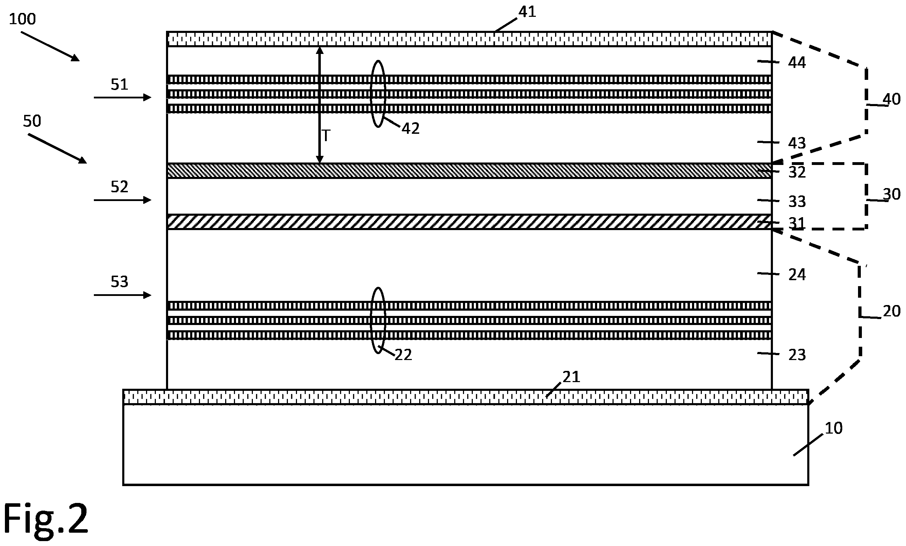

Figure 2 shows the layer stacks and the substrate 10 after a mesa 50 has been formed for instance by dry etching.

In the exemplary embodiment of Figure 2, the mesa 50 comprises a mesa section 51 of the upper layer stack 40, that has been formed by locally removing the upper layer stack 40, a mesa section 52 of the intermediate layer stack 30, that has been formed by locally removing the intermediate layer stack 30, and a mesa section 53 of the lower layer stack 20, that has been formed by locally removing an upper portion of the lower layer stack 20. In the exemplary embodiment of Figure 2, the upper portion includes layers 23 and 24 as well as the reflector 22.

Alternatively, the mesa 50 may only comprise a mesa section 51 of the upper layer stack 40 and a mesa section 52 of the intermediate layer stack 30, or the mesa 50 may only comprise a mesa section 51 of the upper layer stack 40 and an upper portion of the intermediate layer stack 30.

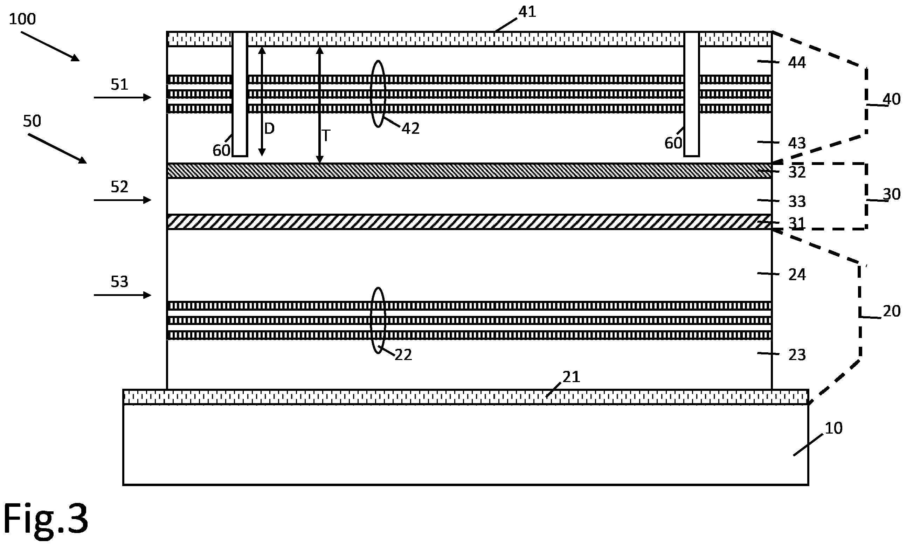

Figure 3 shows the mesa structure of Figure 2 after blind holes 60 have been etched into the mesa 50. The depth D of blind holes 60 is smaller than the thickness T of the upper layer stack 40. Therefore, the blind holes 60 are separated from the intermediate layer stack 30, in particular separated from the active layer 31 and the aperture layer 32.

In other words, since all active layers 31 and all aperture layers 32 of the radiation emitter 100 are exclusively located in the intermediate layer stack 30 and therefore below the upper layer stack 40, these layers 31 and 32 remain unaffected by blind holes: The blind holes 60 neither reach nor interact with the active layer(s) or the aperture layer(s) .

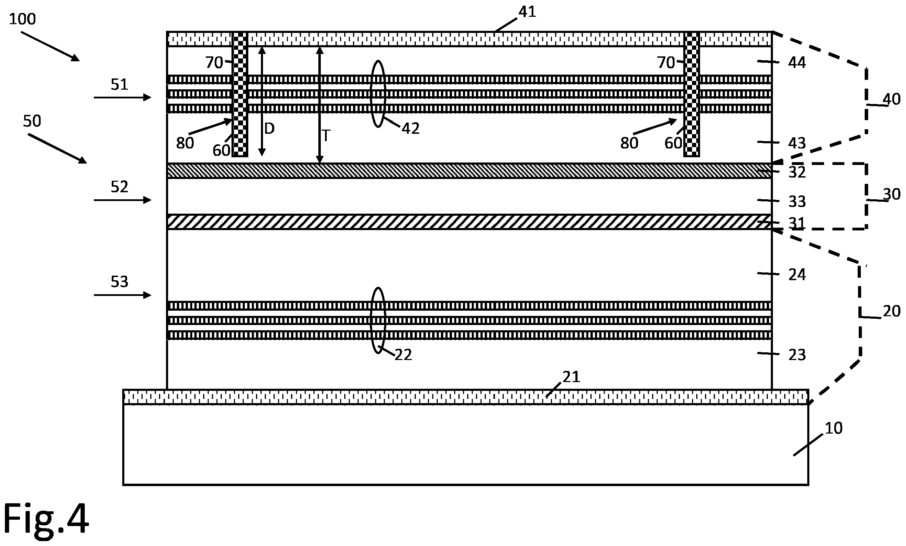

Figure 4 shows the mesa structure of Figure 3 after the blind holes 60 have been filled with a thermally conductive material 70. The thermally conductive material 70 may be an electrical isolator, for instance glass or a ceramic. If the blind holes 60 are filled with a thermally conductive and electrically isolating material, the filled blind holes 60 form thermal but not electrical bypasses 80. The thermal bypasses 80 may for instance allow heat that is generated in the active layer 31, to bypass the upper reflector 42 as shown in Figure 4.

Alternatively, the thermally conductive material 70 may also be electrically conductive. For instance, the thermally conductive material 70 may be a metal, a metal alloy, a conductive polymer, graphite, or a conductive oxide such as for instance ITO. If the blind holes 60 are filled with an electrically conductive material, the filled blind holes 60 form bypasses 80 that are thermally and electrically functional. The thermal and electrical bypasses 80 may for instance allow the electrical laser current and heat that is generated in the active layer 31, to bypass the upper reflector 42 as shown in Figure 4.

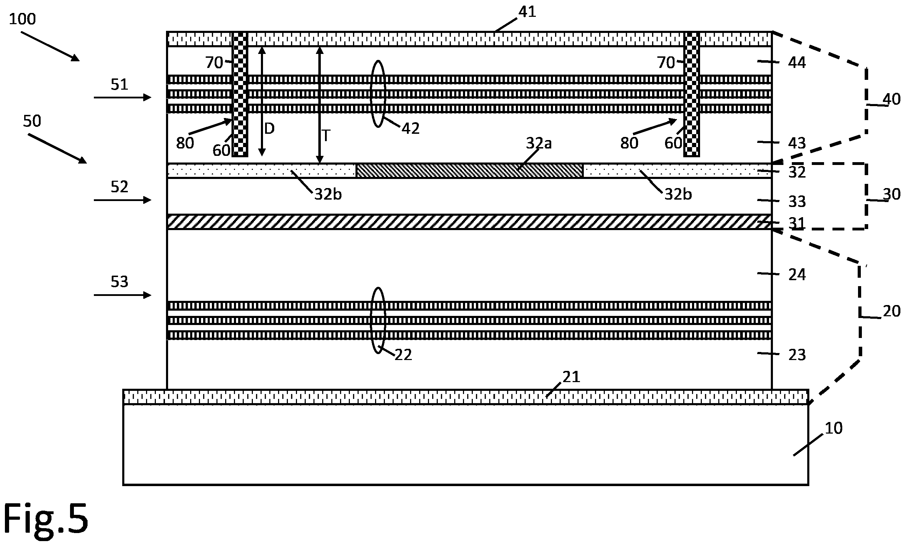

Figure 5 depicts the mesa structure of Figure 4 after the aperture layer 32 is subjected to a lateral oxidation step to provide an unoxidized aperture 32a that is laterally surrounded by oxidized material 32b. Since the blind holes 60 have been filled with the thermally conductive material 70 prior to the lateral oxidation step, the oxidation does not affect the inside surface of the blind holes 60, and for instance not the upper reflector 42 region adjacent to the blind holes 60.

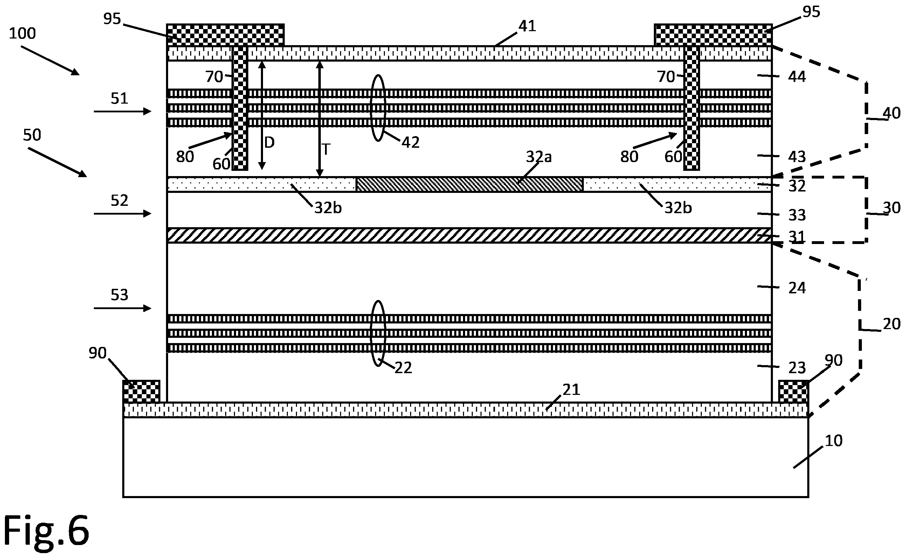

Figure 6 shows the mesa structure of Figure 5 after the lower contact layer 21 is provided with a lower electrically conductive contact material to form a lower electric contact 90 of the radiation emitter, and after the upper contact layer 41 is provided with an upper electrically conductive contact material to form an upper contact 95 of the radiation emitter. The structure shown in Figure 6 forms an exemplary embodiment of a radiation emitter 100, here for instance a VCSEL, according to the present invention.

The upper electrically conductive contact material and the lower electrically conductive contact material may be the same material or different materials. The lower electrically conductive contact material and/or the upper electrically conductive contact material can for instance be a metal, a metal alloy, a conductive polymer, or a conductive oxide such as for instance ITO.

The upper electrically conductive contact material and the thermally conductive material 70 may be different materials. For instance, the upper contact material may be a metal, a metal alloy, a conductive polymer, or a conductive oxide such as for instance ITO, and the thermally conductive material 70 may be glass or ceramic.

Alternatively, the upper electrically conductive contact material and the thermally conductive material 70 may be the same material, for instance a metal, a metal alloy, a conductive polymer, or a conductive oxide such as for instance ITO.

The upper and lower contact 90 and 95 are preferably fabricated in the same step, for instance the same metallization step. Alternatively, the contacts 90 and 95 can be fabricated in different steps, for instance different deposition steps using different materials.

In the exemplary embodiment of Figures 1-6, the step of filling the blind holes 60 with the thermally conductive material 70 and the step or steps of forming the upper and lower contact 90 and 95 are independent steps. More specifically, the step or steps of providing the contacts 90 and 95 is/are carried out after the step of filling the blind holes 60 with the thermally conductive material 70.

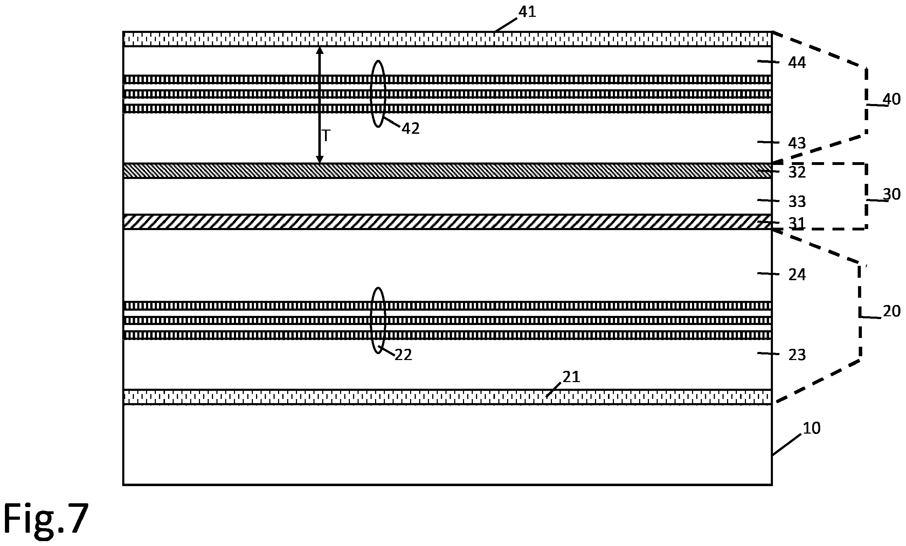

Figures 7-12 depict a second exemplary embodiment of a method of fabricating a radiation emitter according to the present invention.

Figure 7 shows a substrate 10 on which a lower layer stack 20, an intermediate layer stack 30 and an upper layer stack 40 have been fabricated. The layer stacks of Figure 7 may be identical to those described above in connection with the first embodiment of Figures 1-6.

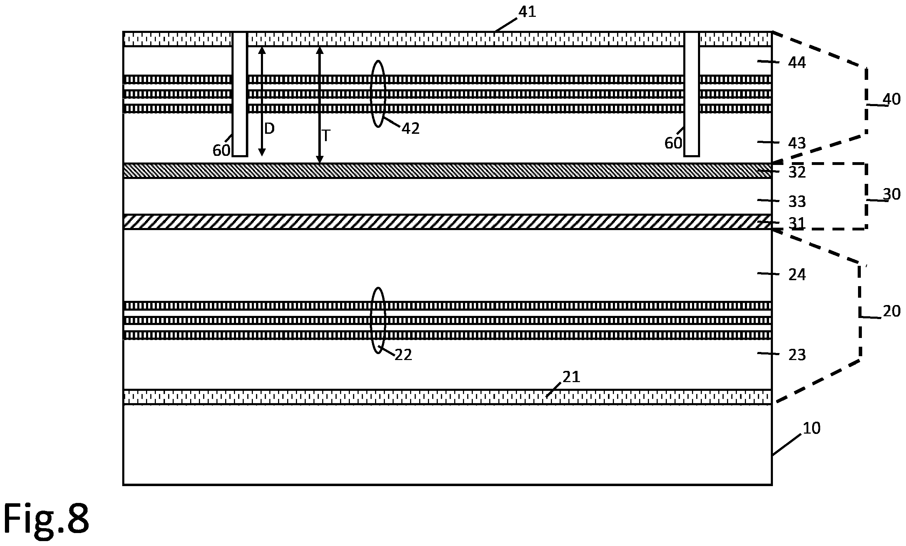

Figure 8 shows the layer stacks and the substrate 10 of Figure 7 after etching the blind holes 60 into the upper layer stack 40. The depth D of blind holes 60 is smaller than the thickness T of the upper layer stack 40. Therefore, the blind holes 60 are separated from the intermediate layer stack 30 that is located beneath.

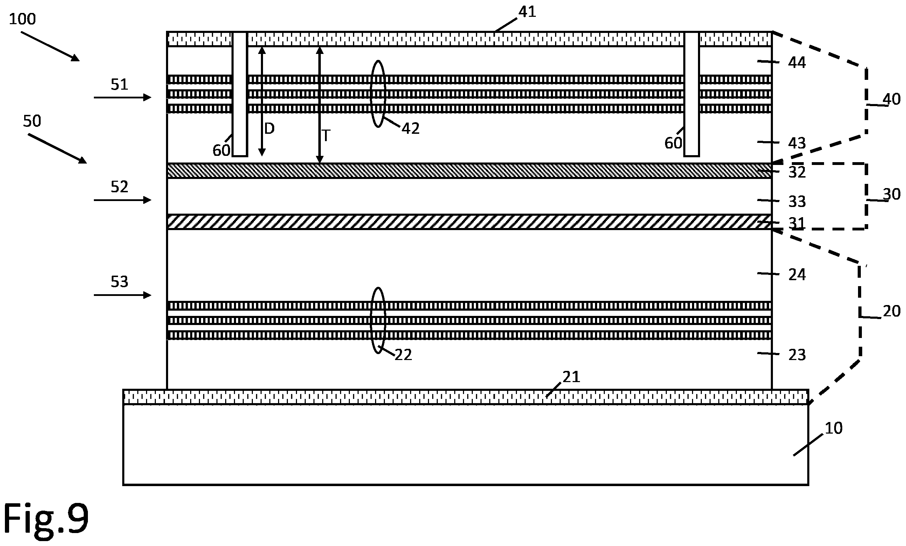

Figure 9 shows the layer stacks and the substrate 10 after a mesa 50 has been formed for instance by dry etching.

In the exemplary embodiment of Figure 9, the mesa 50 comprises a mesa section 51 of the upper layer stack 40, that has been formed by locally removing the upper layer stack 40, a mesa section 52 of the intermediate layer stack 30, that has been formed by locally removing the intermediate layer stack 30, and a mesa section 53 of the lower layer stack 20, that has been formed by locally removing an upper portion of the lower layer stack 20.

Alternatively, the mesa 50 may only comprise a mesa section 51 of the upper layer stack 40 and a mesa section 52 of the intermediate layer stack 30, or the mesa may only comprise a mesa section 51 of the upper layer stack 40 and an upper portion of the intermediate layer stack 30.

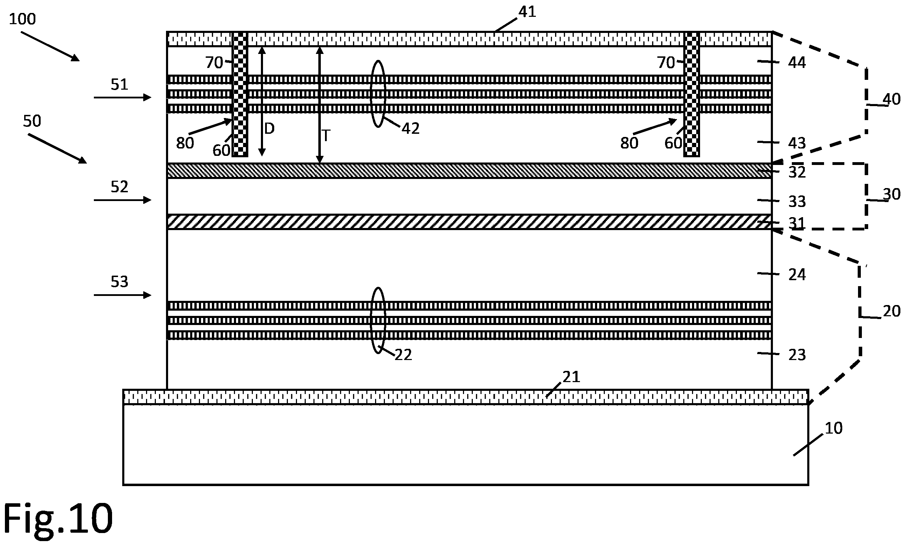

Figure 10 depicts the mesa structure of Figure 9 after the blind holes 60 have been filled with a thermally conductive material 70. The thermally conductive material 70 may be an electrical isolator for instance glass or a ceramic. If the blind holes 60 are filled with a thermally conductive electrical isolator, the filled blind holes 60 may for instance form thermal bypasses 80 for heat that is generated in the active layer 31. The heat may then bypass the upper reflector 42 as shown in Figure 9.

Alternatively, the thermally conductive material 70 may also be electrically conductive. For instance, the thermally conductive material 70 may be a metal, metal alloy or a conductive oxide such as for instance ITO. If the blind holes 60 are filled with an electrically conductive material, the filled blind holes 60 form bypasses 80 that are both thermally and an electrically functional. The bypasses 80 may for instance allow both the electrical laser current and the heat that is generated in the active layer 31, to bypass the upper reflector 42 as shown in Figure 10.

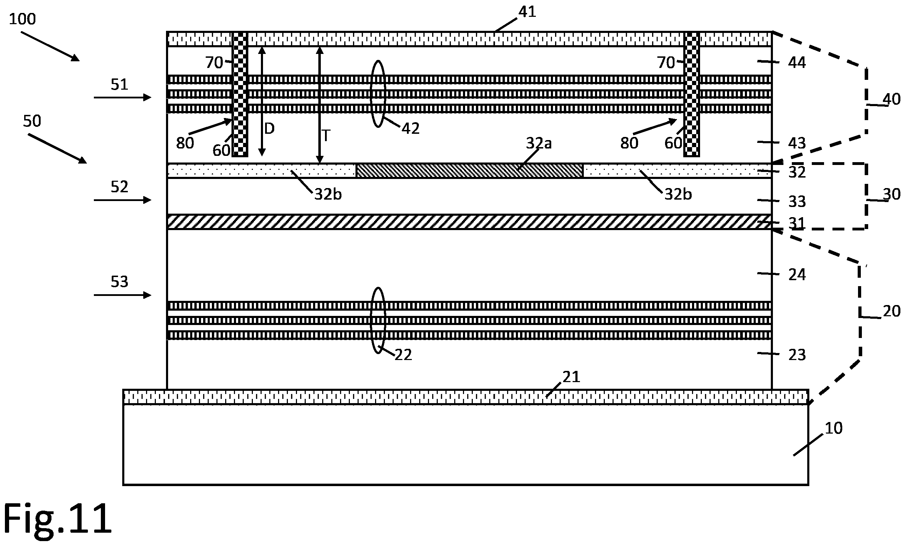

Figure 11 depicts the mesa structure of Figure 10 after the aperture layer 32 is subjected to a lateral oxidation step to provide an unoxidized aperture 32a that is laterally surrounded by oxidized material 32b. Since the blind holes 60 have been filled with the thermally conductive material before the lateral oxidation step is carried out, the oxidation does not affect the inside surface of the blind holes 60, and for instance not the upper reflector 42 region adjacent to the blind holes 60.

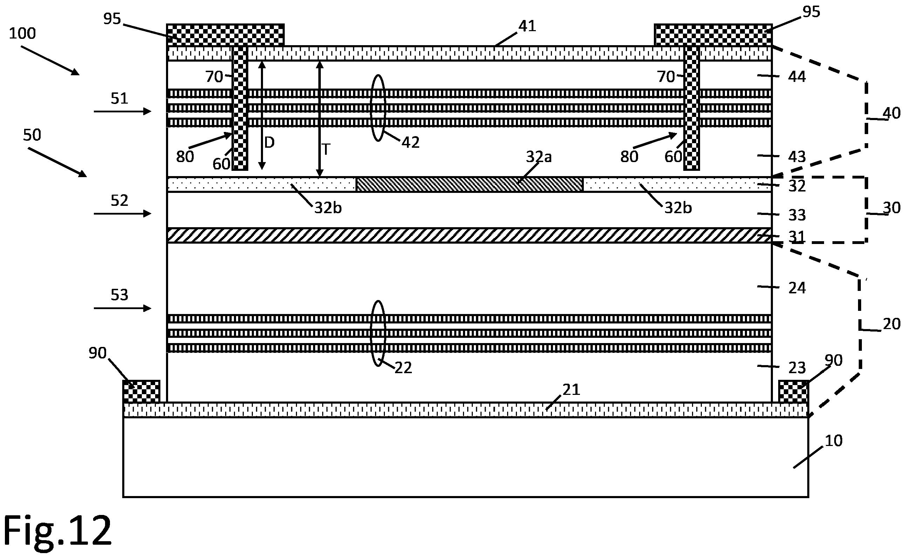

Figure 12 shows the mesa structure of Figure 11 after one or more contacting steps, for instance metallization steps, are carried out. During the contacting step or steps, the lower contact layer 21 is provided with a lower contact material to form a lower electric contact 90 of the radiation emitter, and after the upper contact layer 41 is provided with an upper contact material to form an upper contact 95 of the radiation emitter. The structure shown in Figure 12 forms an exemplary embodiment of a radiation emitter 100, here for instance a VCSEL, according to the present invention.

In the exemplary embodiment of Figures 7-12, the step of filling the blind holes 60 with the thermally conductive material 70 and the step or steps of providing the contact layers with the contact material are independent steps. The step or steps of providing the contact layers with the contact material(s) are carried out after the step of filling the blind holes 60 with the thermally conductive material 70.

The upper contact material and the thermally conductive material 70 may be different materials. For instance, the upper contact material may be a metal, a metal alloy, a conductive polymer, or a conductive oxide such as for instance ITO, and the thermally conductive material 70 may be a thermally conductive but electrically isolating material such as for instance glass or ceramic.

Alternatively, the upper contact material and the thermally conductive material 70 may both be electrically conductive. For instance, the upper contact material and the thermally conductive material 70 may be metals or metal alloys or a conductive oxide such as for instance ITO.

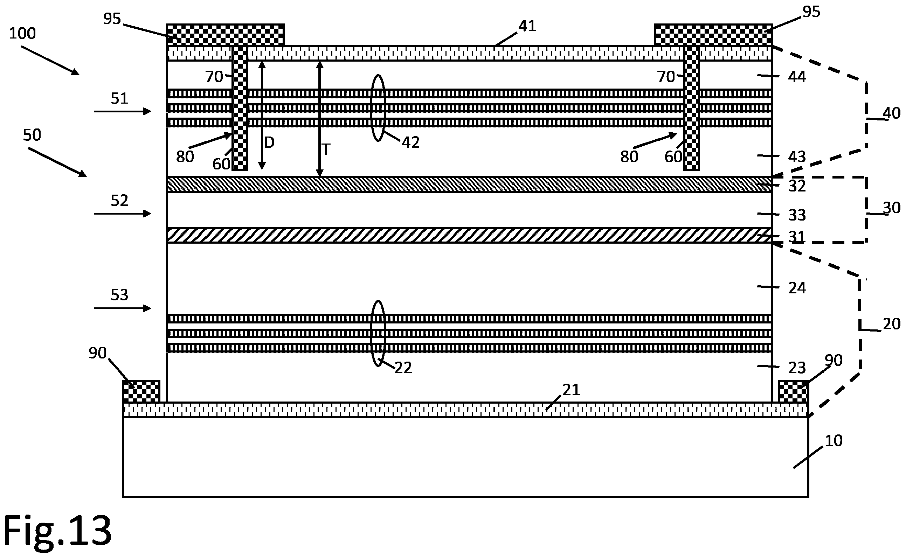

Figures 13-14 in connection with Figures 1-3 or 7-9 depict a third and fourth exemplary embodiment of a method of fabricating a radiation emitter according to the present invention.

Starting from the structure shown in Figure 3 or 9, the blind holes 60 are filled with a thermally conductive material 70. Then, the lower contact layer 21 is provided with a lower contact material to form the lower electric contact 90, and the upper contact layer 41 is provided with the upper contact material to form the upper contact 95 of the radiation emitter. Figure 13 shows the resulting structure before the oxidation step.

In Figure 13, the step of filling the blind holes 60 with the thermally conductive material 70 and the step(s) of providing the upper and lower contact layer with the upper and lower contact material may be independent steps. In this case, the step(s) of providing the contact layers with the contact material(s) are carried out after the step of filling the blind holes 60 with the thermally conductive material 70.

Alternatively, the step of providing the contact layers with the contact material(s) and the step of filling the blind holes 60 with the thermally conductive material 70 can be carried out in a single contacting step, for instance a single metallization step. In latter case, the contact material(s) and the filling material of the blind holes 60 may consist of the same electrically and thermally conductive material such as a metal, a metal alloy, a conductive polymer, or a conductive oxide such as for instance ITO.

After the blind holes 60 are filled and the upper and lower contact are completed, the lateral oxidation step is carried out to fabricate the aperture inside the aperture layer.

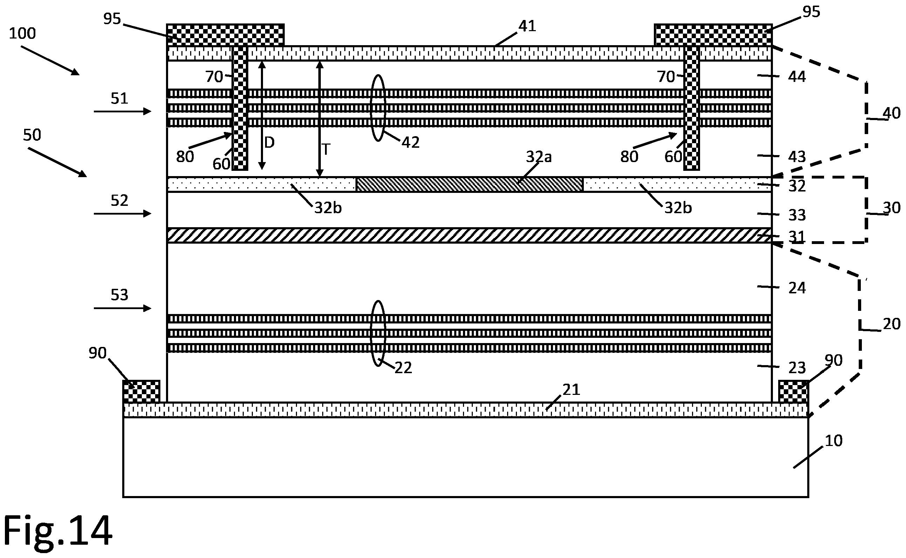

Figure 14 shows the resulting structure which forms an exemplary embodiment of a radiation emitter 100, here for instance a VCSEL, according to the present invention.

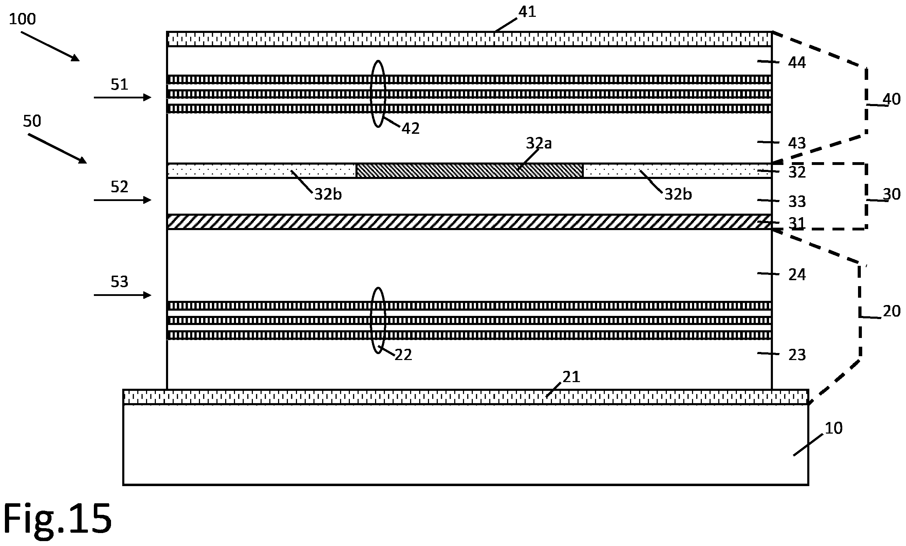

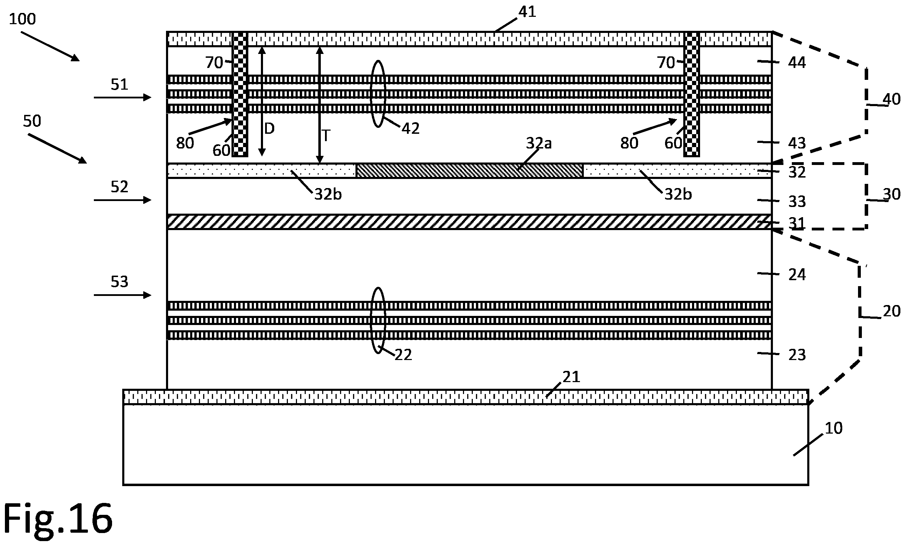

A fifth exemplary embodiment of a method of fabricating a radiation emitter according to the present invention can be obtained if the steps of forming the mesa 50 and oxidizing the aperture layer 32 (see Figure 15) are carried out prior to the step of etching the blind holes 60 and filling the blind holes with the thermally conducting material (see Figure 16).

In the exemplary embodiments described above, the thermal conductivity of the thermally conductive material preferably exceeds 200 W/(K m)at 300 K.

In the exemplary embodiments described above, the thermal conductivity of the thermally and electrical conductive material preferably exceeds 200 W/(K m) at 300 K, and the electrical conductivity of the thermally and electrical conductive material preferably exceeds 8 10⁶ Sm⁻¹ (8 10⁶/ (Ω·m)) .

Suitable metals for forming the upper and lower contacts 90 and 95 and/or filling the blind holes are Gold, Silver, Platinum, Titanium, and Nickel.

Suitable metal alloys for forming the upper and lower contacts 90 and 95 and/or filling the blind holes preferably contain Gold, Silver, Platinum, Titanium, Nickel and/or Gold-Germanium alloys.

In the drawings and specification, there have been disclosed a plurality of embodiments of the present invention. The applicant would like to emphasize that each feature of each embodiment may be combined with or added to any other of the embodiments in order to modify the respective embodiment and create additional embodiments. These additional embodiments form a part of the present disclosure and, therefore, the applicant may file further patent claims regarding these additional embodiments at a later stage of the prosecution.

Further, the applicant would like to emphasize that each feature of each of the following dependent claims may be combined with any of the present independent claims as well as with any other (one ore more) of the present dependent claims (regardless of the present claim structure). Therefore, the applicant may direct further patent claims towards other claim combinations at a later stage of the prosecution.

## Claims

1. Method of fabricating a radiation emitter (100) comprising the steps of
fabricating a lower layer stack (20) on top of a substrate (10), the lower layer stack (20) comprising a lower contact layer (21) and at least one lower reflector (22),
fabricating an intermediate layer stack (30) on top of the lower layer stack (20), the intermediate layer stack (30) comprising at least one active layer (31) and at least one aperture layer (32),
fabricating an upper layer stack (40) on top of the intermediate layer stack (30), the upper layer stack (40) comprising at least one upper reflector (42) and an upper contact layer (41), and
forming a mesa that at least comprises a mesa section of the upper layer stack (40), by locally removing at least the upper layer stack (40),
**characterized in that**
after or before forming the mesa, at least one blind hole (60) having a depth (D) smaller than the thickness (T) of the upper layer stack (40) is etched inside the mesa section of the upper layer stack (40), and
the at least one blind hole (60) is filled with a thermally conductive material (70).

2. Method of claim 1 wherein
the thermally conductive material (70) is also electrically conductive.

3. Method of any of the preceding claims wherein
after etching the mesa
the lower contact layer (21) is provided with a lower contact material to form a lower electric contact (90) of the radiation emitter (100), and
the upper contact layer (41) is provided with an upper contact material to form an upper electric contact (95) of the radiation emitter (100).

4. Method of claim 3 wherein
the step of filling the at least one blind hole (60) with the thermally conductive material (70) and the step of providing the upper contact layer (41) with the upper contact material are independent steps,
wherein the step of providing the upper contact layer (41) with the upper contact material is carried out after the step of filling the at least one blind hole (60) with the thermally conductive material (70).

5. Method of any of the preceding claims 3-4 wherein
the upper contact material and the thermally conductive material (70) are different materials.

6. Method of any of the preceding claims 3-4 wherein
the upper contact material and the thermally conductive material (70) are the same material.

7. Method of any of the preceding claims 1-3 wherein
the step of filling the at least one blind hole (60) with the thermally conductive material (70) and the step of providing the upper contact layer (41) with the upper contact material are carried out in a single contacting step.

8. Method of claim 7 wherein
the upper contact material and the thermally conductive material (70) are the same material.

9. Method of any of the preceding claims wherein
after forming the mesa, the at least one aperture layer (32) is subjected to a lateral oxidation step to provide an unoxidized aperture (32a) that is laterally surrounded by oxidized material (32b).

10. Method of claim 9 wherein
the at least one blind hole (60) is etched and filled with the thermally conductive material (70) after forming the mesa and before laterally oxidizing the aperture layer (32).

11. Method of claim 9 wherein
the at least one blind hole (60) is etched after laterally oxidizing the aperture layer (32).

12. Method of any of the preceding claims 1-9 wherein
the at least one blind hole (60) is etched before forming the mesa, and
the at least one blind hole (60) is filled with the thermally conductive material (70) before laterally oxidizing the aperture layer (32).

13. Method of any of the preceding claims wherein
said step of forming the mesa includes removing the intermediate layer stack (30) or at least an upper portion of the intermediate layer stack (30),
wherein the upper portion of the intermediate layer stack (30) comprises the at least one aperture layer (32).

14. Radiation emitter comprising a mesa (50) that includes at least a mesa section of an upper layer stack (40),
wherein the upper layer stack (40) is located above an intermediate layer stack (30) and comprises an upper contact layer (41) and at least one upper reflector (42),
wherein the intermediate layer stack is located above a lower layer stack (20) and comprises at least one active layer (31) and at least one aperture layer (32), and
wherein the lower layer stack (20) is located on a substrate (10) and comprises a lower contact layer (21) and at least one lower reflector (22),
**characterized in that**
at least one blind hole (60) having a depth (D) smaller than the thickness (T) of the upper layer stack (40) is located inside the upper layer stack (40),
wherein the at least one blind hole (60) is filled with a thermally conductive material (70).

15. Radiation emitter of claim 14,
wherein a plurality of filled blind holes (60) having a depth (D) smaller than the thickness (T) of the upper layer stack (40) is located inside the upper layer stack (40) of the mesa.
